# EUROPEAN PATENT APPLICATION

(11) **EP 2 330 615 A1**
(43) Date of publication of application: **08.06.2011**
(21) Application number: 09817450.1
(22) Date of filing: 28.09.2009
(51) Int. Cl.: H01L 21/304, B24B 37/00

(54) **SILICON CARBIDE SINGLE CRYSTAL SUBSTRATE**

(30) Priority: 30.09.2008 JP 2008252731
(71) Applicant: Showa Denko K.K., Tokyo 105-8518 (JP)
(72) Inventor: SAKAGUCHI, Yasuyuki, Chichibu-shi Saitama 369-1893 (JP)
(74) Representative: Strehl Schübel-Hopf & Partner
(86) International application number: PCT/JP2009/004933
(87) International publication number: WO 2010/038407

(57) **Abstract**

There is provided a silicon carbide single crystal substrate having adhered particles that cause crystal defects removed therefrom and has high surface cleanliness,
the silicon carbide single crystal substrate, wherein a density of first adhered particles attached onto one surface of the substrate and having a height of 100 nm or more is one particle/cm² or less, and also a density of second adhered particles attached onto one surface of the substrate and having a height of less than 100 nm is 1,500 particles/cm² or less.

## Description

### TECHNICAL FIELD

The present invention relates to a silicon carbide single crystal substrate, and in particular, relates to a silicon carbide single crystal substrate with a high degree of surface cleanliness.
Priority is claimed on Japanese Patent Application No. 2008-252731, filed September 30, 2008, the content of which is incorporated herein by reference.

### BACKGROUND ART

In recent years, since silicon carbide (SiC) single crystal materials have excellent semiconductor characteristics such as high power densities and low losses, they are expected to be used as semiconductor device materials. In particular, they are attracting attention as a power electronics semiconductor device in the future.

In general, a semiconductor device is formed by epitaxially growing a plurality of semiconductor layers on one surface of a semiconductor substrate. Since the aforementioned semiconductor layer is a thin film, it is desirable that one surface of the aforementioned semiconductor substrate be polished so as to eliminate unevenness, and it is also desirable that the semiconductor substrate be subjected to a cleaning processing so as to eliminate impurity particles. In those cases where the impurity particles attach to and remain on the surface of the semiconductor substrate, it would be difficult to form an epitaxially grown film, which is to be formed successively, without any defects. In addition, process yields in the formation of surface oxide films are also reduced considerably.

For this reason, several effective cleaning methods in order to remove such impurity particles have been examined. For example, Patent Literature 1 relates to a method of washing semiconductor substrates, and discloses a method of washing semiconductor substrates (silicon wafers or the like) that combines a step for oxidation and reduction, and a rinsing step. As a result, microdamage and metallic impurities caused by the processing of the semiconductor substrate are removed, and the organic deposits on the surface of the semiconductor substrate and impurities on the substrate including the particulates are removed.

In addition, Patent Literature 2 relates to a nitride-based compound semiconductor and a method of washing the compound semiconductor, a production method thereof and a substrate, and as a method that is suitable for washing the nitride-based compound semiconductor, a washing method using a cleaning liquid with a pH of 7.1 or more has been disclosed.

In already available silicon compound semiconductors, it has been possible to eliminate adverse effects of the impurity particles and to deposit an epitaxially grown film with no defects, thereby improving the process yields by using the aforementioned washing method.
However, in the manufacturing process of silicon carbide (SiC) compound semiconductors which involves a step for epitaxial growth, even when a semiconductor substrate cleaned by the use of the aforementioned washing method was used, an abnormal growth or the like still occurred occasionally during the epitaxial growth step, thereby developing crystal defects or the like in the aforementioned thin film.

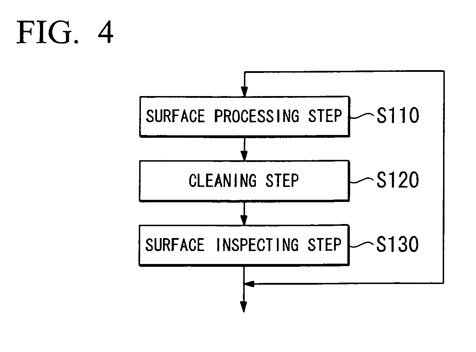

Fig. 4 is a flow chart showing an example of the process for preparing a conventional silicon carbide single crystal substrate. The process for preparing a conventional silicon carbide single crystal substrate is mainly constituted of a surface processing step S110, a cleaning step S120 and a surface inspection step S130. Those products which have passed the surface inspection step S130 are shipped as the final products of silicon carbide single crystal substrates.
The substrates which have failed to pass the surface inspection step S130 are returned to the surface processing step S110, and after being subjected to a necessary surface processing followed by the cleaning step 120, the substrates are subjected to a surface inspection once again in the surface inspection step S130. The substrates which have passed the surface inspection are shipped as the final products, and rejected products continue to go through the above-mentioned cycle of steps until passing the inspection.

Conventionally, for the detection of adhered particles (impurity particles) in the surface inspection step S130, a detection method of scattering an incident light beam in the surface of the semiconductor substrate and visually inspecting the surface or a detection method by using a surface inspection device such as the SurfScan (manufactured by KLA-Tencor Corporation) for inspection has been employed. It should be noted that the SurfScan is a surface inspection device that uses wavelet technology "SURF (Spatial Ultra-efficient Recursive Filtering)". Further, the surface of the semiconductor substrate was cleaned by removing the adhered particles detected in the inspection using a variety of methods for cleaning processing.

In these steps of detection and cleaning processing, adhered particles that are smaller than the wavelength of the incident light beam used for detection are assumed to be beyond the optical detection limit of this method, and thus are not included in the adhered particles to be removed. In other words, as long as a conventional detection method is used, the semiconductor substrates in which such small adhered particles are remaining in large amounts are treated as the semiconductor substrates which have been subjected to a cleaning processing.
There was a possibility that persistence of such adhered particles which were impossible to detect by the conventional methods and having a size that goes beyond the optical detection limit was responsible for causing the abnormal growth or the like during the epitaxial growth, and still developing the crystal defect and the like in the aforementioned thin film.

### [Patent Literature]

[Patent Literature 1]
   Japanese Unexamined Patent Application, First Publication No. 2003-282511
[Patent Literature 2]
   Japanese Unexamined Patent Application, First Publication No. 2006-352075

### DISCLOSURE OF INVENTION

The present invention takes the above circumstances into consideration, with an object of providing a silicon carbide single crystal substrate having the adhered particles that cause crystal defects removed therefrom and exhibiting a high level of surface cleanliness.

In order to achieve the aforementioned objects, the present invention has adopted the following aspects. That is:
(1) A silicon carbide single crystal substrate characterized in that a density of first adhered particles attached onto one surface of the substrate and having a height of 100 nm or more is one particle/cm² or less, and also a density of second adhered particles attached onto one surface of the substrate and having a height of less than 100 nm is 1,500 particles/cm² or less.
(2) The silicon carbide single crystal substrate according to the above aspect (1) characterized in that the density of the second adhered particles is 100 particles/cm² or less.
(3) The silicon carbide single crystal substrate according to the above aspect (1) or (2) characterized by being formed through a surface processing step for adhered particle reduction, in which the surface is polished using a polishing cloth impregnated with a pH adjuster and an abrasive constituted of diamond abrasive grain.

(4) The silicon carbide single crystal substrate according to the above aspect (3) characterized in that the density of the second adhered particles is measured by conducting a surface inspection using an atomic force microscope (AFM) prior to the aforementioned surface processing step for adhered particle reduction.
(5) The silicon carbide single crystal substrate according to the above aspect (3) or (4) characterized in that the aforementioned pH adjuster adjusts pH of the surface of the aforementioned silicon carbide single crystal substrate to 3 or less.
(6) The silicon carbide single crystal substrate according to any one of the above aspects (3) to (5) characterized in that the aforementioned pH adjuster adjusts pH of the surface of the aforementioned silicon carbide single crystal substrate to 2 or less.

(7) The silicon carbide single crystal substrate according to any one of the above aspects (3) to (6) characterized in that the aforementioned polishing cloth is further impregnated with an oxidizing agent and/or a soft solidifying agent.
(8) The silicon carbide single crystal substrate according to the above aspect (7) characterized in that the aforementioned soft solidifying agent contains at least one metal oxide composed of silicon, aluminum, cerium or chromium.
(9) The silicon carbide single crystal substrate according to the above aspect (7) or (8) characterized in that the aforementioned oxidizing agent is an aqueous solution containing at least one of sulfuric acid, chlorine, ozone, a hypochlorite salt, a fluorine ion and a bromine ion.

According to the above-mentioned aspects, a silicon carbide single crystal substrate having the adhered particles that cause crystal defects removed therefrom and exhibiting a high level of surface cleanliness can be provided.

### BRIEF DESCRIPTION OF THE DRAWINGS

Fig. 1 is a flow chart showing an example of the process for preparing a silicon carbide single crystal substrate of the present invention.
Fig. 2 is an atomic force micrograph showing a surface profile of the silicon carbide single crystal substrate of the present invention prior to the surface processing step for adhered particle reduction.
Fig. 3 is an atomic force micrograph showing a surface profile of the silicon carbide single crystal substrate of the present invention following the surface processing step for adhered particle reduction.
Fig. 4 is a flow chart showing an example of the process for preparing a conventional silicon carbide single crystal substrate.

### DESCRIPTION OF EMBODIMENTS

Hereinafter, an embodiment of the present invention will be described.

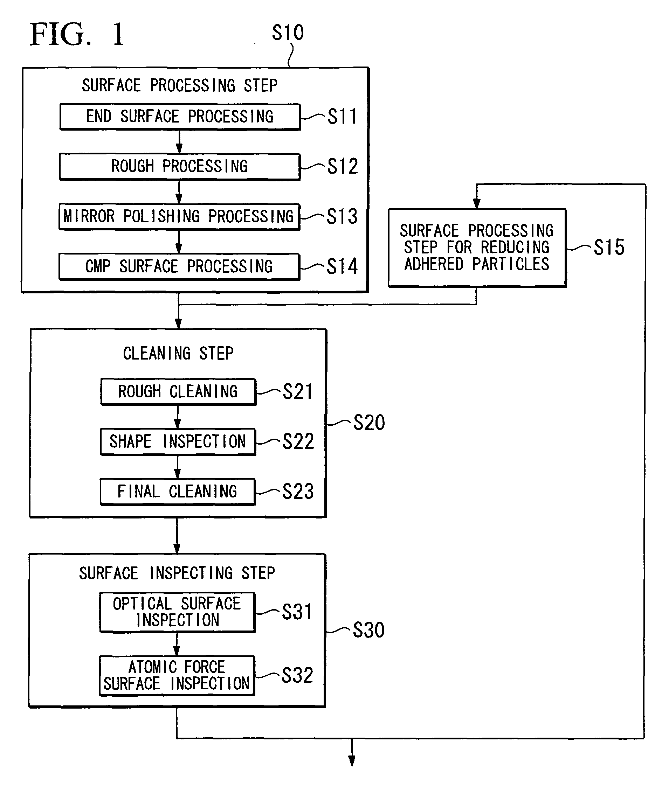

Fig. 1 is a flow chart showing an example of the process for preparing a conventional silicon carbide single crystal substrate which is an embodiment of the present invention. The preparation process for the silicon carbide single crystal substrate, which is an embodiment of the present invention, is mainly constituted of a surface processing step S10, a cleaning step S20, a surface inspection step S30 and a surface processing step S15 for adhered particle reduction.
The surface processing step S10 is constituted of an end surface processing step S11, a rough processing step S12, a mirror polishing processing step S13 and a surface processing step S14 by chemical mechanical polishing (CMP), and the cleaning step S20 is constituted of a rough cleaning step S21, a shape inspection step S22 and a final cleaning step S23. In addition, the surface inspection step S30 is constituted of an optical surface inspection step S31 and a surface inspection step using an atomic force microscope (AFM) (atomic force microscopic surface inspection) S32. The silicon carbide single crystal substrates which have passed the atomic force microscopic surface inspection step S32 are shipped as the final products.
The substrates which have failed to pass the surface inspection step S30 are returned to the surface processing step S15 for adhered particle reduction, and after being subjected to a surface processing followed by the cleaning step 20, the substrates are subjected to a surface inspection once again in the surface inspection step S30. The substrates which have passed the surface inspection are shipped as the final products, and rejected products continue to go through the above-mentioned cycle of steps until passing the inspection.

### <surface processing step S10>

First, a silicon carbide single crystal ingot formed by a sublimation method or the like is cut to form a silicon carbide single crystal wafer (i.e., a silicon carbide single crystal substrate), which is then subjected to the end surface processing step S11. More specifically, edges of the end faces on both sides of the aforementioned silicon carbide single crystal substrate which were cut substantially at the right angle are processed into a circular arc shape with a radius of about 50 to 200 µm by grinding or the like.

Next, the rough processing step S12 is conducted on the surface of the aforementioned silicon carbide single crystal substrate. The rough processing step S12 is a processing, in which the aforementioned silicon carbide single crystal substrate is placed between the two flat surface plates, and the two flat surface plates are opposed to each other and rotated while supplying an abrasive, thereby cutting both sides of the aforementioned silicon carbide single crystal substrate to adjust the thickness and to improve the flatness.

Subsequently, the mirror polishing processing step S13 is conducted on the surface of the aforementioned silicon carbide single crystal substrate. The mirror polishing processing step S13 is a processing method similar to that of the rough processing step, which is a processing for removing irregularities and scratches on the surface of the aforementioned silicon carbide single crystal substrate and obtaining an optically flat mirror surface by pasting a nonwoven fabric or the like onto the planes of the two flat surface plates and supplying a finer abrasive thereto.

Then, the surface processing step S14 by chemical mechanical polishing (CMP) is conducted on the surface of the aforementioned silicon carbide single crystal substrate. The surface processing step S14 by chemical mechanical polishing (CMP) is a processing that removes the fine scratches and layers damaged by the process which remain on the surface of the aforementioned silicon carbide single crystal substrate due to the surface processing through a chemical mechanical mechanism.
For example, it is a processing in which several of the aforementioned silicon carbide single crystal substrates are attached evenly, using wax or the like, onto a flat base (plate) prepared with a ceramic or the like, and a plane of the aforementioned silicon carbide single crystal substrate is pressed and rotated via this plate while supplying a working fluid to the rotating surface plates onto which a nonwoven fabric of the like is attached, thereby removing the surface of the aforementioned silicon carbide single crystal substrate extremely thinly. As a result, the surface damage of the aforementioned silicon carbide single crystal substrate can be removed, and the aforementioned silicon carbide single crystal substrate will be provided with a mirror-like surface. It should be noted that chromium oxide or the like is used in the working fluid employed in the present surface processing step.

Following the completion of the CMP surface processing step S14, the aforementioned plate is detached from the processing machine, followed by the removal of the aforementioned working fluid, and the aforementioned silicon carbide single crystal substrate with a mirror-like surface is then separated from the aforementioned plate. The aforementioned specular silicon carbide single crystal substrate which has been separated is then transferred to a vessel for washing and subjected to the cleaning step S20.

Note that it is preferable to wash the substrate for one minute or more by supplying pure water prior to the cleaning step S20 and following the surface processing step S10. As a result, the second adhesion particles can be further reduced.
For example, following the completion of the surface processing step, the plate is attached to a one side processing machine and a surface washing is conducted for five minutes by supplying only pure water. Thereafter, the plate is detached from this machine, and after washing with water, the silicon carbide single crystal substrate is separated from the plate.

### <Cleaning step S20>

Subsequently, the rough cleaning step S21 is conducted on the aforementioned specular silicon carbide single crystal substrate. In the rough cleaning step S21, the RCA clean which is a common method for washing the semiconductor substrates is used. The RCA clean is a method for cleaning the semiconductor substrates which is developed by the Radio Corporation of America (RCA) in the United States, and is a method for cleaning at high temperatures using a chemical solution, to which hydrogen peroxide, an alkali and an acid have been added. It should be noted that the drugs, the conditions and the like that are employed in the method differ depending on the semiconductor substrate manufacturers.

For example, the aforementioned specular silicon carbide single crystal substrate is sequentially immersed in the following chemical tanks. The chemical tanks are composed of an acetone tank, a methanol tank, a pure water tank, an SPM tank (containing a mixed solution of sulfuric acid and hydrogen peroxide), a pure water tank, an SC1 tank (containing an aqueous mixed solution of ammonia and hydrogen peroxide), a pure water tank, a hydrofluoric acid tank, a pure water tank, an SC2 tank (containing an aqueous mixed solution of hydrochloric acid and hydrogen peroxide), a pure water tank, a hydrofluoric acid tank, a pure water tank and an IPA tank. Note that if necessary, the specular silicon carbide single crystal substrate immersed in each tank is subjected to operations such as the fluctuations and the ultrasonic waves. Following the immersion processing in the IPA tank, the aforementioned specular silicon carbide single crystal substrate pulled out of the IPA tank is subjected to a drying processing through the IPA vapor drying.

Then, the shape inspection step S22 is conducted. In the shape inspection, the degree of flatness (indicated by GSBR or Warp) of the aforementioned specular silicon carbide single crystal substrate is measured using a flatness tester, and the final thickness thereof is also measured using an optical micrometer.

Next, the final cleaning step S23 is conducted. The final cleaning step S23 is basically the same as the previous, rough cleaning step S21 with the exception that the remaining particles in the cleaning fluid or the like and the frequency of use of the fluid are controlled, thereby further improving the cleanliness level. The aforementioned specular silicon carbide single crystal substrate which has been subjected to the final cleaning step S23 is then subjected to the surface inspection step S30 described below.

### <Surface inspection step S30>

First, the optical surface inspection step S31 is conducted on the silicon carbide single crystal substrate. In the optical surface inspection step S31, a conventional surface inspection is employed, and the scratches, tarnish, adhered particles or the like on the surface is inspected mainly by visual observation through the naked eye or an optical microscope or by the use of SurfScan (manufactured by KLA-Tencor Corporation).
Since the light is used as a detection means in the above optical surface inspection, the size (both the height and the diameter) of an object to be measured is in theory larger than the light wave length (i.e., 100 nm (0.1 µm) or more). As a result, the size, the number and the position of adhered particles whose height is 100 nm or more can be known. Note that hereafter, the adhered particles whose height is 100 nm or more will be referred to as the first adhered particles.
It is preferred that the density of the aforementioned first adhered particles be one particle/cm² or less. When the density of the aforementioned first adhered particles is one particle/cm² or less, abnormal growth during the epitaxial growth caused by the first adhered particles can be suppressed.

### <Atomic force microscopic surface inspection>

Next, a surface inspection step using an atomic force microscope (AFM) (atomic force microscopic surface inspection) S32 is carried out. The atomic force microscopic surface inspection S32 is a surface inspection using an atomic force microscope (AFM), the particles having a height from 0.05 nm up to 0.5 µm can be observed. As a result, the size, the number and the position of adhered particles whose height is less than 100 nm can be known. Note that hereafter, the adhered particles whose height is less than 100 nm will be referred to as the second adhered particles.

It is preferable that the density of the aforementioned second adhered particles be 1,500 particles/cm² or less, and more preferably 100 particles/cm² or less. When the density of the aforementioned second adhered particles is 1,500 particles/cm² or less, abnormal growth during the epitaxial growth caused by the second adhered particles can be suppressed.
That is, by reducing not only the density of the first adhered particles but also the density of the second adhered particles, the surface cleanliness on the silicon carbide single crystal wafer substrate can be further improved, an epitaxially grown film can be formed without any defects, and the process yield of silicon carbide single crystal semiconductor can be improved.

There are no particular limitations on the material for the aforementioned second adhered particles. Examples thereof include the diamond grains contained in the abrasive and the silicon compound particles generated from the substrate. As for the size of the aforementioned second adhered particles, many of them are observed to have a height of 0.5 to 2 nm.

The aforementioned second adhered particles are attached onto the surface of the silicon carbide single crystal substrate in a chemically stable state. For this reason, the second adhered particles cannot be removed completely in many cases by the conventional washing step alone.
It should be noted that in those cases where Si, GaAs, InP or the like is used as a substrate, the impurity particles (adhered particles) on the substrate surface do not attach to the surface of the substrate in a chemically stable state, and not only the first adhered particles but also the second adhered particles are easily removed by the application of the conventional washing step.

The silicon carbide single crystal substrates which have passed the atomic force microscopic surface inspection step S32 are shipped as the final products. The silicon carbide single crystal substrates which are rejected are then subjected to the surface processing step S15 for adhered particle reduction.

### <surface processing step for adhered particle reduction S15>

The surface processing step for adhered particle reduction S15 is a step of reducing the density of the second adhered particles by polishing the surface using an abrasive constituted of a polishing cloth impregnated with a pH adjuster and diamond abrasive grains.
By adjusting the pH in the surface of the silicon carbide single crystal substrate, the chemical bond between the surface of the silicon carbide single crystal substrate and the adhered particles can be weakened, which makes it easy to remove the second adhered particles that are attached in a chemically stable manner. By polishing the surface in that state using an abrasive constituted of diamond abrasive grains, the second adhered particles that are attached in a chemically stable manner can be removed.

It is preferable that the aforementioned pH adjuster adjust the pH of the surface of the aforementioned silicon carbide single crystal substrate to 3 or less, and more preferably 2 or less. By making the surface of the silicon carbide single crystal substrate acidic, it becomes easy to remove the second adhered particles that are attached in a chemically stable manner.

It is preferred that the polishing cloth is further impregnated with an oxidizing agent, and the oxidizing agent is preferably an aqueous solution containing at least one of sulfuric acid, chlorine, ozone, a hypochlorite salt, a fluorine ion and a bromine ion. By making the surface of the silicon carbide single crystal substrate acidic, it becomes easy to remove the second adhered particles that are attached in a chemically stable manner.

It is preferred that the polishing cloth is further impregnated with a soft solidifying agent, and the soft solidifying agent preferably contains at least one metal oxide composed of silicon, aluminum, cerium or chromium. As a result, the second adhered particles that are attached in a chemically stable manner can be removed.

In the surface processing step for adhered particle reduction S15, a surface processing is carried out by combining the components and processes described above.
For example, as a first method, a mirror polishing processing is carried out by using a polishing cloth impregnated with a pH adjuster that adjusts the pH of the surface of the silicon carbide single crystal substrate to 2 or less and diamond abrasive grains. Alternatively, as a second method, a mirror surface processing is carried out by using a polishing cloth impregnated with an oxidizing agent and a soft solidifying agent, and the mirror polishing processing is conducted by adjusting the pH to 3 or less by the use of a pH adjuster, and also by using a soft solidifying agent that contains at least one oxides of silicon, aluminum, cerium and chromium, and an aqueous solution containing at least one of sulfuric acid, chlorine, ozone, a hypochlorite salt, a fluorine ion and a bromine ion as an oxidizing agent.

In addition, in the present embodiment, although the surface inspection step S32 that uses an atomic force microscope (AFM) is carried out after the cleaning step 20 and the surface processing step for adhered particle reduction S15 is carried out after measuring the density of the second adhered particles, the surface processing step for adhered particle reduction S15 may be carried out after the surface processing step S10.
In this manner, one step that constitutes the cleaning step can be reduced, thereby streamlining the process for preparing a silicon carbide single crystal substrate.

Since the silicon carbide single crystal substrate which is the embodiment of the present invention has a constitution in which the density of the first adhered particles that are attached onto one surface of the substrate and having a height of 100 nm or more is one particle/cm² or less and also the density of the second adhered particles that are attached onto one surface of the substrate and having a height of less than 100 nm is 1,500 particles/cm² or less, it is possible to suppress abnormal growth during the epitaxial growth caused by the second adhered particles and to improve the process yield of silicon carbide single crystal semiconductors.

The silicon carbide single crystal substrate which is the embodiment of the present invention preferably have a constitution in which the density of the aforementioned second adhered particles is 100 particles/cm2 or less. Because of this constitution, it is possible to suppress abnormal growth during the epitaxial growth caused by the second adhered particles and to further improve the process yield of silicon carbide single crystal semiconductors.

Since the silicon carbide single crystal substrate which is the embodiment of the present invention is formed by carrying out the surface processing step for adhered particle reduction S15 to polish the surface using a polishing cloth impregnated with a pH adjuster and an abrasive constituted of diamond abrasive grains, it is possible to suppress abnormal growth during the epitaxial growth caused by the second adhered particles and to improve the process yield of silicon carbide single crystal semiconductors.

Since the silicon carbide single crystal substrate which is the embodiment of the present invention has a constitution in which the density of the aforementioned second adhered particles is measured by carrying out the surface inspection step S32 using an atomic force microscope (AFM) prior to the surface processing step for adhered particle reduction S15, it is possible to suppress abnormal growth during the epitaxial growth caused by the second adhered particles and to improve the process yield of silicon carbide single crystal semiconductors.

Since the silicon carbide single crystal substrate which is the embodiment of the present invention has a constitution in which a pH adjuster adjusts the pH of the surface of the aforementioned silicon carbide single crystal substrate to 3 or less, it is possible to suppress abnormal growth during the epitaxial growth caused by the second adhered particles and to improve the process yield of silicon carbide single crystal semiconductors.

Since the silicon carbide single crystal substrate which is the embodiment of the present invention has a constitution in which a pH adjuster adjusts the pH of the surface of the silicon carbide single crystal substrate to 2 or less, it is possible to suppress abnormal growth during the epitaxial growth caused by the second adhered particles and to improve the process yield of silicon carbide single crystal semiconductors.

Since the silicon carbide single crystal substrate which is the embodiment of the present invention has a constitution in which a polishing cloth is further impregnated with an oxidizing agent and/or a soft solidifying agent, it is possible to suppress abnormal growth during the epitaxial growth caused by the second adhered particles and to improve the process yield of silicon carbide single crystal semiconductors.

Since the silicon carbide single crystal substrate which is the embodiment of the present invention has a constitution in which a soft solidifying agent contains at least one metal oxide composed of silicon, aluminum, cerium or chromium, it is possible to suppress abnormal growth during the epitaxial growth caused by the second adhered particles and to improve the process yield of silicon carbide single crystal semiconductors.

Since the silicon carbide single crystal substrate which is the embodiment of the present invention has a constitution in which an oxidizing agent is an aqueous solution containing at least one of sulfuric acid, chlorine, ozone, a hypochlorite salt, a fluorine ion and a bromine ion, it is possible to suppress abnormal growth during the epitaxial growth caused by the second adhered particles and to improve the process yield of silicon carbide single crystal semiconductors.
The present invention will be described below in more detail, based on a series of examples. However, the present invention is in no way limited by these specific examples.

### [Examples]

### (Example 1)

A silicon carbide single crystal substrate (a sample of Example 1) was prepared by employing the process for preparing a silicon carbide single crystal substrate shown in the flow chart of Fig. 1.

### <surface processing step>

First, a silicon carbide single crystal substrate having a diameter of about 50 mmϕ with an inclination angle of 8° with respect to the (0001) plane was prepared, and was subjected to a predetermined end surface processing .
Subsequently, a rough processing was carried out, in which the silicon carbide single crystal substrate was placed between the two flat surface plates, and the two surface plates were opposed to each other and rotated while supplying an abrasive, thereby cutting both sides of the silicon carbide single crystal substrate to adjust the thickness and to improve the flatness. Diamond abrasive grains were used as the abrasive grains for processing.
Then, a mirror polishing processing was carried out, in which a nonwoven fabric or the like was attached onto the planes of the two flat surface plates, the silicon carbide single crystal substrate was placed between the two surface plates, and the two surface plates were opposed to each other and rotated while supplying a finer abrasive, thereby cutting both sides of the silicon carbide single crystal substrate to adjust the thickness and to improve the flatness. During this process, much finer diamond abrasive grains were used. As a result, an optically flat mirror surface having a surface roughness Ra of about 5 nm was obtained.

Then, a CMP surface processing was carried out, in which a several of the silicon carbide single crystal substrates were attached evenly, using wax or the like, onto a flat base (plate) prepared with a ceramic or the like, and the surface of the silicon carbide single crystal substrate was pressed and rotated via this plate while supplying a working fluid to the rotating surface plates onto which a nonwoven fabric of the like was attached, thereby removing the surface of the silicon carbide single crystal substrate extremely thinly.
It should be noted that during this process, it was configured so that a Si polar face was made as a finished surface, and one side polishing was conducted for the surface processing by attaching the C polar face side onto a low-expansion glass plate. As a working fluid, a hypochlorous acid-based oxidizing agent was added to a commercially available aqueous colloidal silica solution. As a result, a processed surface having a surface roughness Ra of 0.05 nm or less was obtained.

Following the completion of the surface processing step, the plate was attached to a one side processing machine and a surface washing was conducted for five minutes by supplying only pure water. The plate diameter was 380ϕ, the rotational frequency of surface plate was 60 rpm, and a pressure applied on the surface of the silicon carbide single crystal substrate was 25 kPa. Then, the plate was detached from this machine, and after washing with water, the silicon carbide single crystal substrate was separated from the plate.

### <Cleaning step>

The separated silicon carbide single crystal substrate was subjected to a rough cleaning. The RCA clean, in which a cleaning was conducted at a high temperature using a chemical solution added with hydrogen peroxide, an alkali and an acid, was used for the rough cleaning.
More specifically, the substrate was sequentially immersed in the following chemical tanks, and subjected to operations such as the fluctuations and the ultrasonic waves. The chemical tanks were composed of an acetone tank, a methanol tank, a pure water tank, an SPM tank (containing a mixed solution of sulfuric acid and hydrogen peroxide), a pure water tank, an SC1 tank (containing an aqueous mixed solution of ammonia and hydrogen peroxide), a pure water tank, a hydrofluoric acid tank, a pure water tank, an SC2 tank (containing an aqueous mixed solution of hydrochloric acid and hydrogen peroxide), a pure water tank, a hydrofluoric acid tank, a pure water tank and an IPA tank. Following the immersion processing in the IPA tank, and while being pulled out of the IPA tank, the substrate was subjected to a drying processing through the IPA vapor drying.
Subsequently, a shape inspection using a flatness tester and an optical micrometer was carried out, thereby confirming that the degree of flatness was within an allowable range. Then, a final cleaning was conducted through the RCA clean in the same manner as the rough cleaning.

### <Surface inspection step>

First, an inspection by dark field visual observation and an optical surface inspection using the SurfScan (manufactured by KLA-Tencor Corporation) were conducted on the silicon carbide single crystal substrate subjected to the final cleaning. In the silicon carbide single crystal substrate, no scratch or tarnish was observed on the surface thereof.

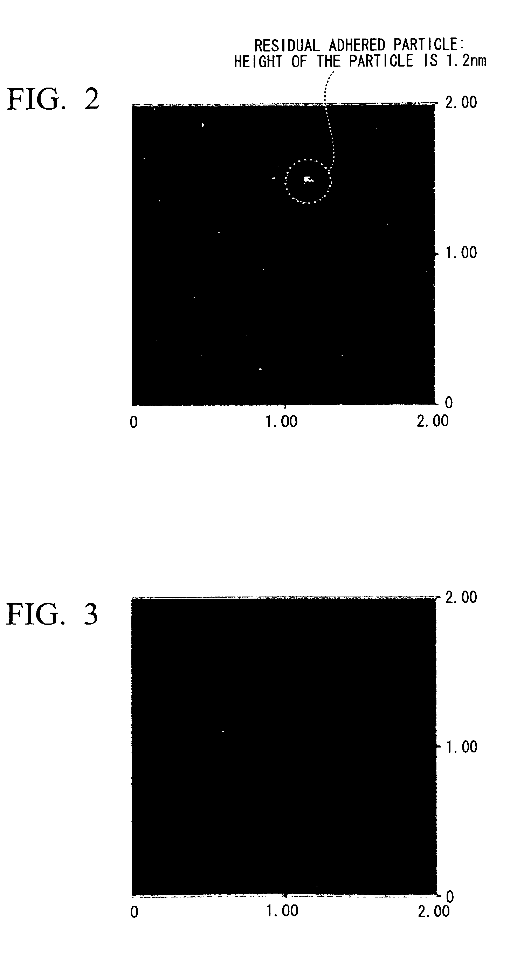

Subsequently, an atomic force microscopic surface inspection was conducted. Fig. 2 is a photograph of the surface of the silicon carbide single crystal substrate obtained through the atomic force microscopic surface inspection. One residual adhered particle having a height of 1.2 nm was observed in a measuring area shown in Fig. 2. By conducting an atomic force microscopic surface inspection in addition to an optical surface inspection which is a conventional surface inspection process, it became clear that fine adhered particles, which had conventionally been impossible to detect, were persistent.

For this reason, a surface processing step for adhered particle reduction (a mirror polishing processing) was conducted using an abrasive constituted of diamond abrasive grains and a polishing cloth impregnated with a pH adjuster. At this time, the pH of the surface of the silicon carbide single crystal substrate was adjusted to 1 with the pH adjuster. Then, after repeating the aforementioned cleaning step, a surface inspection step was carried out once again.

In the inspection of the silicon carbide single crystal substrate by dark field visual observation and the optical surface inspection using the SurfScan (manufactured by KLA-Tencor Corporation), no scratch or tarnish was observed on the surface of the silicon carbide single crystal substrate, and the number of adhered particles or the like that were equal to or larger than 0.1 µm was zero (i.e., zero particle/cm²) in the entire surface.
Fig. 3 is a photograph of the surface of the silicon carbide single crystal substrate obtained through the atomic force microscopic surface inspection. Not a single adhered particle having a height of 0.5 nm or larger and less than 100 nm was observed in a measuring area shown in Fig. 3. By measuring all over the surface of the silicon carbide single crystal substrate in this manner using an AFM, it became clear that the density of the adhered particles having a height of 0.5 nm or larger and less than 100 nm was 100 particles/cm². Note that the surface roughness Ra of the silicon carbide single crystal substrate was 0.1 nm or less.

A silicon carbide semiconductor was prepared by epitaxially growing a thin film of silicon carbide single crystal having a thickness of several micrometers to a few tens of micrometers on this silicon carbide single crystal substrate. Density of the abnormal growth points generated during this epitaxial growth step was 120 points/cm²

### (Example 2)

Following the completion of the surface processing step, the plate was attached to a one side processing machine, and a silicon carbide single crystal substrate (a sample of Example 2) was prepared in the same manner as in Example 1 with the exception that a surface washing was conducted for one minute by supplying only pure water.

After conducting a surface processing step for adhered particle reduction (a mirror polishing processing) by using an abrasive constituted of diamond abrasive grains and a polishing cloth impregnated with a pH adjuster while adjusting the pH of the surface of the silicon carbide single crystal substrate to 1, the aforementioned cleaning step was repeated. Then, a surface inspection step was carried out once again.
In the inspection of the silicon carbide single crystal substrate by dark field visual observation and the optical surface inspection using the SurfScan (manufactured by KLA-Tencor Corporation), no scratch or tarnish was observed on the surface of the silicon carbide single crystal substrate, and the number of adhered particles or the like that were equal to or larger than 0.1 µm was one (i.e., 1 particle/cm²) in the entire surface.
Subsequently, by measuring all over the surface of the silicon carbide single crystal substrate using an AFM, it became clear that the density of the adhered particles having a height of 0.5 nm or larger and less than 100 nm was 1,500 particles/cm².

A silicon carbide semiconductor was prepared by epitaxially growing a thin film of silicon carbide single crystal having a thickness of several micrometers to a few tens of micrometers on this silicon carbide single crystal substrate. Density of the abnormal growth points generated during this epitaxial growth step was 1,700 points/cm².

### (Comparative Example 1)

A silicon carbide single crystal substrate (a sample of Comparative Example 1) was prepared by employing the process for preparing a conventional silicon carbide single crystal substrate shown in the flow chart of Fig. 4.
First, a surface treating step was conducted in the same manner as in Example 1. Then, the plate was detached from the processing machine, and after removing the working fluid by washing with water, the silicon carbide single crystal substrate was separated from the plate.
Then, after conducting a cleaning step constituted of a rough cleaning, a shape inspection and a final cleaning in the same manner as in Example 1, a surface inspection step was carried out.

In the inspection of the silicon carbide single crystal substrate by dark field visual observation and the optical surface inspection using the SurfScan (manufactured by KLA-Tencor Corporation), no scratch or tarnish was observed on the surface of the silicon carbide single crystal substrate, and the number of adhered particles or the like that were equal to or larger than 0.1 µm was two (i.e., 2 particles/cm²) in the entire surface.
Subsequently, by measuring all over the surface of the silicon carbide single crystal substrate using an AFM, it became clear that the density of the adhered particles having a height of 0.5 nm or larger and less than 100 nm was 1 × 10⁴ particles/cm².

A silicon carbide semiconductor was prepared by epitaxially growing a thin film of silicon carbide single crystal having a thickness of several micrometers to a few tens of micrometers on this silicon carbide single crystal substrate. Density of the abnormal growth points generated during this epitaxial growth step was 2.5 × 10⁴ points/cm².

The conditions for preparing silicon carbide single crystal substrates and the inspection results thereof are summarized in Table 1. It became clear that there was a corresponding relationship between the number (density) of adhered particles detected by an AFM and the number (density) of abnormal growth points.

**[Table 1]**

| Detection means | SurfScan | AFM | Visual observation |
|---|---|---|---|
| Detected objects | Adhered particles | Adhered particles | Abnormal growth points |
| Particle size | ≥ 0.1 µm | 0.1µm to 0.5 nm | - |
| Example 1 | 0 (particle/cm²) | 100 (particles/cm²) | 120 (points/cm²) |
| Example 2 | 1 (particle/cm²) | 1,500 (particles/cm²) | 1,700 (points/cm²) |
| Comparative Example 1 | 2 (particles/cm²) | 10,000(particles/cm²) | 25,000 (points/cm²) |

### INDUSTRIAL APPLICABILITY

The present invention relates to a silicon carbide single crystal substrate with a high degree of surface cleanliness and can be applied in the field of producing high power devices, high-temperature-resistant device materials, radiation-resistant device materials, high frequency device materials, or the like which use the silicon carbide silicon crystals, and also in the field of using these devices and materials.

## Claims

1. A silicon carbide single crystal substrate,
wherein a density of first adhered particles attached onto one surface of the substrate and having a height of 100 nm or more is one particle/cm² or less, and also
a density of second adhered particles attached onto one surface of the substrate and having a height of less than 100 nm is 1,500 particles/cm² or less.

2. The silicon carbide single crystal substrate according to Claim 1, wherein the density of the second adhered particles is 100 particles/cm² or less.

3. The silicon carbide single crystal substrate according to Claim 1,
wherein the substrate is formed through a surface processing step for adhered particle reduction, in which a surface is polished using a polishing cloth impregnated with a pH adjuster and an abrasive constituted of diamond abrasive grain.

4. The silicon carbide single crystal substrate according to Claim 3,
wherein the density of the second adhered particles is measured by conducting a surface inspection using an atomic force microscope (AFM) prior to the surface processing step for adhered particle reduction.

5. The silicon carbide single crystal substrate according to Claim 3,
wherein the pH adjuster adjusts pH of the surface of the silicon carbide single crystal substrate to 3 or less.

6. The silicon carbide single crystal substrate according to Claim 3,
wherein the pH adjuster adjusts pH of the surface of the silicon carbide single crystal substrate to 2 or less.

7. The silicon carbide single crystal substrate according to Claim 3,
wherein the polishing cloth is further impregnated with an oxidizing agent and/or a soft solidifying agent.

8. The silicon carbide single crystal substrate according to Claim 7,
wherein the soft solidifying agent contains at least one metal oxide composed of silicon, aluminum, cerium or chromium.

9. The silicon carbide single crystal substrate according to Claim 7,
wherein the oxidizing agent is an aqueous solution containing at least one of sulfuric acid, chlorine, ozone, a hypochlorite salt, a fluorine ion and a bromine ion.
